# EUROPÄISCHE PATENTANMELDUNG

(11) **EP 3 147 940 A1**
(43) Veröffentlichungstag der Anmeldung: **29.03.2017**
(21) Anmeldenummer: 15186272.9
(22) Anmeldetag: 22.09.2015
(51) Int. Cl.: H01L 23/473

(54) **KÜHLKÖRPER**

(71) Anmelder: Siemens Aktiengesellschaft, 80333 München (DE)
(72) Erfinder: Kraus, Ludwig, 94099 Ruhstorf (DE)

(57) **Zusammenfassung**

Die Erfindung betrifft einen Kühlkörper (1) zur Übertragung von Wärme einer Wärmequelle (2) auf ein flüssiges Kühlmedium (3) und wobei der Kühlkörper (1) mindestens einen Kanal (4) zur Aufnahme des flüssigen Kühlmediums (3) aufweist. Um auf die Verwendung von Wärmeleitpaste bei der thermischen Kontaktierung von Wärmequelle (2) und Kühlkörper (1) verzichten zu können wird vorgeschlagen, dass der Kühlkörper (1) eine Folie (5) aufweist, wobei die Folie (5) zumindest einen Teil des Kanals (4) bildet, wobei die Folie (5) eine Außenfläche (6), des Kühlkörpers (1) bildet, die für die Kontaktierung mit der Wärmequelle (2) vorgesehen ist, wobei die Folie (5) derart flexibel ist, dass die Folie (5) durch einen Druck des flüssigen Kühlmediums (3) an die Wärmequelle (2) gedrückt wird. Weiter betrifft die Erfindung ein Kühlsystem (20) mit einem solchen Kühlkörper (1), und einem Mittel zur Druckerzeugung (24), wobei durch das Mittel (24) zur Druckerzeugung das flüssige Kühlmedium (3) derart unter Druck setzbar ist, dass die Folie (5) durch den Druck des flüssigen Kühlmediums (3) an die Wärmequelle gedrückt wird. Des Weiteren betrifft die Erfindung ein Verfahren zur Kühlung einer Wärmequelle (2) mittels eines solchen Kühlkörpers, wobei das flüssige Kühlmedium (3) derart unter Druck gesetzt wird, dass die Folie (4) des Kühlkörpers (1) an die Wärmequelle (2) gedrückt wird.

## Beschreibung

Die Erfindung betrifft einen Kühlkörper zur Übertragung von Wärme einer Wärmequelle auf ein flüssiges Kühlmedium, wobei der Kühlkörper mindestens einen Kanal zur Aufnahme des flüssigen Kühlmediums aufweist. Die Erfindung betrifft weiter eine Leistungshalbleitereinheit mit einem solchen Kühlkörper und einem Halbleitermodul. Ferner betrifft die Erfindung ein Kühlsystem mit einem solchen Kühlkörper oder einer solchen Leistungshalbleitereinheit sowie einer Pumpe, einem Wärmetauscher und einem Rohrsystem. Des Weiteren betrifft die Erfindung ein Verfahren zur Kühlung einer Wärmequelle mittels eines solchen Kühlkörpers.

Ein Kühlkörper wird dazu verwendet, die Wärme einer Wärmequelle an die Umgebung abzuführen. Insbesondere auf dem Gebiet der Leistungshalbleiter ist es erforderlich, im Leistungshalbleiter entstehende Verlustleistung, die sich in Form von Wärme äußert, an die Umgebung abzuführen.

Bedingt durch ihre Eigenschaften entstehen beim Betrieb von Halbleitermodulen (im Folgenden auch als Module bezeichnet), beispielsweise in Stromrichtern, Verluste, die an die Umgebung abgeführt werden müssen. Zu diesem Zweck werden die Module auf Kühlkörper montiert, deren Kühlfinnen die Verluste direkt an die Kühlluft (Umgebungsluft) abgeben, oder auf Kühlkörper, die ein flüssiges Kühlmittel aufweisen und über das flüssige Kühlmittel die Wärme transportieren und an einer anderen Stelle, zum Beispiel an einem Wärmetauscher, diese an die Umgebungsluft abgeben.

Das Halbleitermodul weist zum Abführen der entstehenden Verlustwärme eine Kupferbodenplatte auf. Über diese Kupferbodenplatte ist das Halbleitermodul mit dem Kühlkörper verbunden. Bei den genannten Halbleitermodulen sind häufig auf der Kupferbodenplatte elektrisch isolierende Keramikplättchen (sogenannte DCBs) mit den Halbleiterchips aufgelötet. Bedingt durch die unterschiedlichen thermischen Ausdehnungskoeffizienten von Kupfer und Keramik entstehen mechanische Spannungen, die den Kupferboden wölben. Bei Montage auf einem ebenen Kühlkörper entstehen zwischen Kühlkörper und Halbleitermodul Lufteinschlüsse. Bei den Lufteinschlüssen handelt es sich um schlecht wärmeleitende Hohlräume. Diese befinden sich nachteiliger Weise ausgerechnet dort, wo durch die Halbleiter die größten Verluste eingespeist werden.

Es gibt verschiedene Methoden, den Nacheil der Hohlräume beim Wärmeübergang zu überwinden. Die am häufigsten angewendete Methode besteht darin, den Modulboden vor der Montage mit einer Wärmeleitpaste (Thermal Interface Material, oftmals abgekürzt als TIM) zu beschichten. Diese füllt dann die Hohlräume aus. Überschüssige Wärmeleitpaste an Stellen, an denen deren Schichtdicke vor der Montage größer war als der Hohlraum, wird verdrängt und sammelt sich am Modulrand.

Eine weitere Methode verwendet als Kühlkörper eine offene Wanne, auf der das Modul befestigt und am Rand abgedichtet ist. Das Modul dient dabei als Art Deckel des Kühlkörpers, der ein Austreten des flüssigen Kühlmittels verhindert. Das Kühlmittel strömt unmittelbar am Modulboden entlang. Wölbungen des Modulbodens spielen hier keine Rolle, da sich das Kühlmedium den Unebenheiten anpasst. Nachteilig ist jedoch, dass bei der Demontage des Moduls, z.B. bei einer Reparatur innerhalb einer elektrischen Anlage wie beispielsweise einem Stromrichter, der gesamte Kühlkreislauf oder zumindest einige Teile des Kühlkreislaufs entleert werden muss. Für den Zeitraum, bis das Austauschmodul montiert ist, ist der Kühlkreislauf geöffnet mit dem der Nachteil, dass dann Fremdköper in den Kühlkreislauf gelangen können und später Komponenten des Kühlsystems beschädigen können. Damit steigt die Wahrscheinlichkeit für den Ausfall oder der Beschädigung weiterer Komponenten der elektrischen zu kühlenden Anlage, wie beispielsweise einem Stromrichter.

Der Erfindung liegt die Aufgabe zugrunde, einen Kühlkörper anzugeben, der auch ohne die Verwendung von Wärmeleitpaste Lufteinschlüsse bei der Verbindung einer Wärmequelle mit gewölbter Oberfläche mit dem Kühlkörper vermeidet und bei dem die Wärmequelle vom Kühlkörper derart trennbar ist, dass keine Gefahr des Austretens des Kühlmittels besteht.

Die Aufgabe wird durch einen Kühlkörper zur Übertragung von Wärme einer Wärmequelle auf ein flüssiges Kühlmedium gelöst, wobei der Kühlkörper mindestens einen Kanal zur Aufnahme des flüssigen Kühlmediums aufweist, wobei der Kühlkörper eine Folie aufweist, wobei die Folie zumindest einen Teil des Kanals bildet, wobei die Folie eine Außenfläche des Kühlkörpers bildet, die für die Kontaktierung mit der Wärmequelle vorgesehen ist, wobei die Folie derart flexibel ist, dass die Folie durch einen Druck des flüssigen Kühlmediums an die Wärmequelle gedrückt wird. Die Aufgabe wird weiter durch eine Leistungshalbleitereinheit mit einem solchen Kühlkörper und einem Halbleitermodul gelöst, wobei das Halbleitermodul derart auf dem Kühlkörper angeordnet ist, dass das Halbleitermodul thermisch zumindest mit Teilen der Folie des Kühlkörpers gekoppelt ist. Ferner wird die Aufgabe durch ein Kühlsystem mit einem solchen Kühlkörper oder einer solchen Leistungshalbleitereinheit sowie einer Pumpe, einem Wärmetauscher und einem Verbindungssystem gelöst, wobei der Kühlkörper, die Pumpe und der Wärmetauscher mittels des Verbindungssystems derart miteinander verbunden sind, dass das flüssige Kühlmedium zwischen dem Kühlkörper, der Pumpe und dem Wärmetauscher zirkulieren kann, wobei durch die Pumpe das flüssige Kühlmedium derart unter Druck setzbar ist, dass die Folie durch den Druck des flüssigen Kühlmediums an die Wärmequelle gedrückt wird. Darüber hinaus wird die Aufgabe durch Verfahren zur Kühlung einer Wärmequelle mittels eines solchen Kühlkörpers gelöst, wobei das flüssige Kühlmedium derart unter Druck gesetzt wird, dass die Folie des Kühlkörpers an die Wärmequelle gedrückt wird.

Vorteilhafte Ausgestaltungen der Erfindung sind in den abhängigen Ansprüchen angegeben.

Der Erfindung liegt die Erkenntnis zu Grunde, dass Halbleitermodule mit unebenem oder gewölbtem Boden sich dadurch optimal kühlen lassen, dass der Kühlkörper mit der für das flüssige Kühlmedium notwendigen Struktur zum Halbleitermodul hin nicht mit einem starren Deckel oder einer glatten Oberfläche, sondern mit einer geeigneten Folie abgeschlossen wird. Damit ergibt sich eine deutlich geringere Anforderung an die Beschaffenheit der Fläche der Wärmequelle, die mit dem Kühlkörper kontaktiert wird und mittels des Kühlkörpers zu kühlen ist. Diese muss nicht mehr eben sein sondern kann Wölbungen oder Unebenheiten aufweisen. Diese Wölbungen oder Unebenheiten können dauerhaft vorhanden sein oder sich erst durch Erwärmung der Wärmequelle beispielsweise im Betrieb ergeben. Das flüssige Kühlmedium des Kühlkörpers ist derart unter Druck setzbar, dass eine Außenfläche, die für die Kontaktierung mit der Wärmequelle vorgesehen ist, sich in ihrer Form ändert. Durch diese Formänderung sind Abweichungen von einer komplett ebenen Oberfläche der Wärmequelle, die gekühlt werden soll, ausgleichbar. Lufteinschlüsse und/oder Hohlräume, die den Wärmeübergang zwischen Wärmequelle und Kühlkörper verschlechtern, können dadurch vermieden oder zumindest deutlich reduziert werden. Der Vorgang des Kühlens wird auch als Entwärmen bezeichnet. Der Kühlkörper mit seiner Folie passt sich an die Unebenheit der jeweiligen Wärmequelle, insbesondere an die exemplarabhängige Unebenheit eines Halbleitermoduls, an. Die Verwendung von Wärmeleitpaste ist nicht mehr erforderlich, da keine Lufteinschlüsse zwischen Kühlkörper und Wärmequelle mehr vorhanden sind. Dies vereinfacht den Montageprozess und senkt Produktionskosten.

Durch die Bewegung der Folie kann, allerdings nicht notwendigerweise, sich ein veränderter Kanal für das Kühlmedium derart ausbilden, so dass sich der Weg des Kühlmediums in Abhängigkeit vom Druck des Kühlmediums innerhalb des Kühlkörpers ändert.

Halbleitermodule haben oftmals die Eigenschaft, dass diese eine Kupfer-Bodenplatte zur Abfuhr der Wärme aufweisen und mindestens ein Keramikplättchen aufweisen, das zwischen Kupfer-Bodenplatte und Halbleiterchip angeordnet ist. Aufgrund der unterschiedlichen thermischen Ausdehnungskoeffizienten von Kupfer und Keramik entstehen an der Fläche der Bodenplatte, die für die Kontaktierung mit einem Kühlkörper vorgesehen ist, Unebenheiten, wie beispielsweise Wölbungen. Diese Wölbungen eignen sich aufgrund ihrer Ausgestaltung (Radien) insbesondere um durch die Folie des Kühlkörpers ausgeglichen zu werden. Dabei hat es sich als vorteilhaft erwiesen, die Folie des Kühlkörpers nur am Rand des Halbleitermoduls mit der Kühlplatte zu verbinden, und zwar so, dass dort eine dichte Verbindung entsteht, die das Austreten von flüssigem Kühlmedium aus dem Kühlkörper verhindert. Dabei wird das Austreten des flüssigen Kühlmediums auch dann verhindert, wenn das flüssige Kühlmedium unter Druck gesetzt wird.

Die Wärmequelle kann direkt mit der Folie im thermischen Kontakt stehen. Damit ist der Wärmewiderstand zwischen Wärmequelle und Kühlkörper besonders niedrig, so dass ein großer Wärmeübergang bei geringen Temperaturdifferenzen stattfinden kann. Alternativ oder ergänzend ist es auch möglich, zwischen der Folie und Wärmequelle eine weitere wärmeleitfähige Schicht einzubringen, auf die die Wärmequelle montiert wird. Durch diese weitere wärmeleitfähige Schicht kann dem Aufbau aus Wärmequelle und Kühlkörper eine höhere Stabilität verliehen werden.

Der Transport der Wärme kann durch das flüssige Kühlmedium durch die Bewegung des Kühlmediums erreicht werden. Dies wird oftmals als Flüssigkeitskühlung bezeichnet. Alternativ oder ergänzend ist es möglich, den Wärmetransport durch Verdampfen und Kondensation des flüssigen Kühlmediums zu erreichen, wie es beispielsweise in einer Heatpipe-Kühlung geschieht. Prinzipiell ist der Kühlkörper unter anderem für beide dieser Kühlarten geeignet.

Das Kühlsystem muss wahlweise drucklos sein oder unter einem Vordruck stehen können. Solange im Kühlsystem kein Überdruck herrscht, ist die Folie eben und liegt nur punktuell an der Wärmequelle, insbesondere an der Kupferbodenplatte des Halbleitermoduls Modulboden, an. Wird nun beispielsweise mittels der Pumpe ein Druck im flüssigen Kühlmedium aufgebaut, dann legt sich die Folie vollflächig an den Boden des Halbleitermoduls und stellt einen guten Wärmeübergang zwischen Modulboden und Kühlmedium her, der keinen Hohlraum oder keinen Lufteinschluss mehr aufweist.

Vorteilhafterweise besitzt das Kühlsystem einen geschlossenen internen Kühlkreislauf und gibt die Wärme bzw. Verlustleistung dann über geeignete Wärmetauscher an ein Kühlmittel der Umgebung (Luft, Industriewasser, Seewasser, etc.) ab. Dadurch bleibt der interne Aufbau des Kühlkörpers immer gleich, unabhängig davon, in welcher Form die Wärme an die Umgebung abgeführt wird.

Der von der Wahl des Kühlmittels der Umgebung unabhängige, interne Kühlkreislauf bietet die Möglichkeit, wahlweise einen Vordruck aufzubauen oder abzulassen. Er bietet weiter die Gewähr dafür, dass der Boden des Halbleitermoduls keinem unzulässigen Druck, keinen Drückstößen oder unerwünschten Druckschwankungen ausgesetzt ist.

Ein weiterer Vorteil dieser Anordnung besteht darin, dass das flüssige Kühlmedium nicht mit dem Boden der Wärmequelle in Kontakt kommt. Es besteht insbesondere bei Halbleitermodulen mit einer Kupferbodenplatte keine Gefahr, dass an dieser Bodenplatte unerwünschte, chemische Reaktionen mit dem flüssigen Kühlmedium auftreten.

Ein weiterer Vorteil dieser Anordnung besteht darin, dass die Wärmequelle auf einfache Weise von dem Kühlkörper getrennt werden kann, ohne ein Öffnen oder Entleeren des Kühlkreislaufes durchzuführen. Eine Beschädigung der Wärmequelle, insbesondere eine Beschädigung von Halbleitermodulen, die empfindlich gegenüber dem Eindringen von Flüssigkeiten sind, kann zuverlässig vermieden werden, da ein Austreten des flüssigen Kühlmediums durch die Folie verhindert wird. Für die Demontage der Wärmequelle muss lediglich der Vordruck des Kühlmediums abgelassen und vor Wiederinbetriebnahme, beispielsweise mithilfe einer kleinen Handpumpe, wieder aufgebaut werden. Darüber hinaus ist mittels der Folie eine einfache, kostengünstige und zuverlässige Verbindungschicht zwischen Wärmequelle und Kühlkörper realisierbar.

Bei einer weiteren vorteilhaften Ausgestaltung weist die Oberfläche der Folie, die zum Innern des Kanals gerichtet ist, eine größere Rauigkeit auf als eine weitere Oberfläche, welche die Außenfläche des Kühlkörpers bildet. Die unterschiedlichen Rauigkeit lassen sich im Fertigungsprozess der Folie auf unterschiedliche, aber einfache Weise erzielen. Die hohe Rauigkeit auf der Seite der Folie, die mit dem flüssigen Kühlmedium in Kontakt steht bewirkt eine für den Wärmeübergang große, wirksame Fläche. Auch lassen sich Turbulenzen im flüssigen Kühlmedium in unmittelbarer Nähe der Folie durch die hohe Rauigkeit erzielen, die einen effizienten Wärmeübergang sicherstellen.

Bei einer weiteren vorteilhaften Ausgestaltung weist eine Oberfläche der Folie, die zum Innern des Kanals gerichtet ist, hervorstehende Elemente, insbesondere Noppen und/oder Rillen, oder eine schaumartige Beschichtung, insbesondere eine Beschichtung mit Metallschaum, auf. Diese hervorstehenden Elemente bzw. diese schaumartige Beschichtung vergrößert die für den Wärmeübergang von der Folie zum flüssigen Kühlmedium wirksame Fläche innerhalb des Kühlkörpers. Durch die entsprechend große wirksame Fläche kann eine entsprechend große Wärmemenge dem flüssigen Kühlmedium bei geringer Temperaturdifferenz zwischen Kühlkörper und Wärmequelle zugeführt werden. Darüber hinaus kann durch die hervorstehenden Elemente und/oder der schaumartigen Beschichtung eine Turbulenz im flüssigen Kühlmedium erzeugt werden, welche den Wärmeübergangswert zwischen Folie und Kühlmedium weiter verbessert. Die Elemente und/oder die Beschichtung lassen sich auf einfache Weise auf der Oberfläche der Folie auftragen.

Bei einer weiteren vorteilhaften Ausgestaltung weist die Oberfläche der Folie, die zum Innern des Kanals gerichtet ist, eine hohe Querleitfähigkeit für die Wärmeleitung auf. Die Querleitfähigkeit bewirkt eine Spreizung der durch die Folie hindurchtretenden Wärme. Damit ist die wirksame Fläche für den Übergang der Wärme von der Folie zum flüssigen Kühlmedium größer als die wirksame Fläche für den Übergang der Wärme von der Wärmequelle zur Folie. Dadurch ist ein effizienter Wärmetransport mit geringem Temperaturhub von der Oberfläche des Kühlkörpers zum flüssigen Kühlmedium realisierbar.

Im Folgenden wird die Erfindung anhand der in den Figuren dargestellten Ausführungsbeispiele näher beschrieben und erläutert. Es zeigen:
- FIG 1: eine Wärmequelle auf einem Kühlkörper,
- FIG 2: eine Wärmequelle mit aufgetragener Wärmeleitpaste,
- FIG 3: eine Wärmequelle mit aufgetragener Wärmeleitpaste montiert auf einem Kühlkörper,
- FIG 4: einen Kühlkörper mit unmittelbarer Bodenkühlung,
- FIG 5: einen Kühlkörper mit einer Folie,
- FIG 6: einen Kühlkörper mit Folie
- FIG 7: einen Kühlkörper mit Folie und montierter Wärmequelle,
- FIG 8: ein Kühlsystem,
- FIG 9: eine Folie mit Noppen,
- FIG 10: eine Folie mit Rillen,
- FIG 11: eine Folie mit Metallschaum und
- FIG 12: eine Folie mit hoher Querleitfähigkeit.

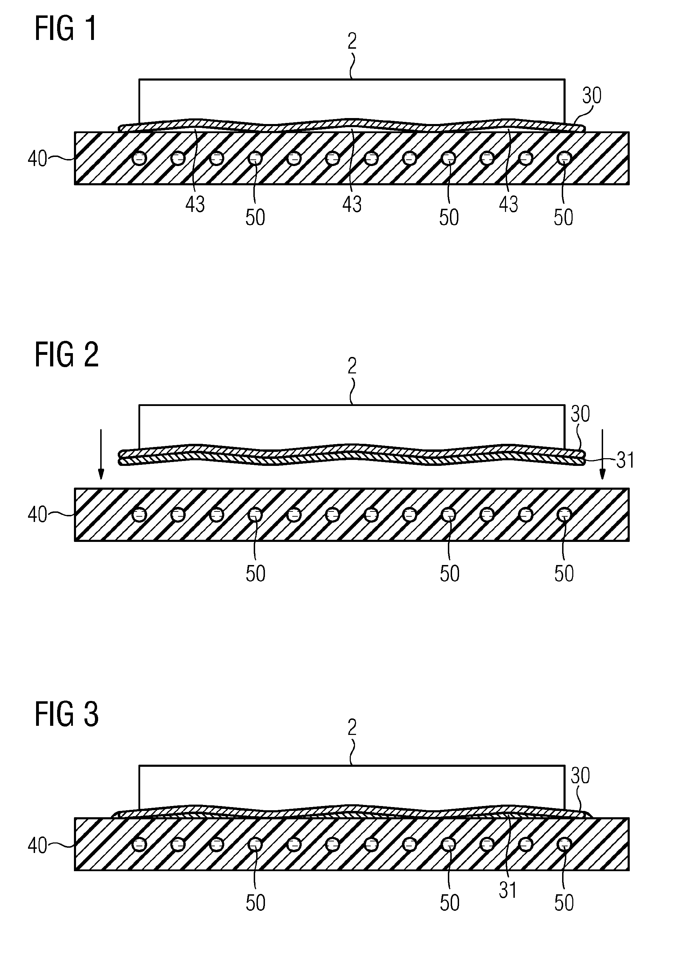

FIG 1 zeigt eine Kühlplatte 40 mit einer darauf montierten Wärmequelle 2 aus dem Stand der Technik. Die Kühlplatte wird von einem Kühlmedium 50, beispielsweise Wasser, durchströmt. Die Wärmequelle 2 weist einen Boden 30 mit Unebenheiten auf. Diese Unebenheiten sind in dieser Figur als stark übertriebene Wölbungen dargestellt. Es ist zu erkennen, dass zwischen dem Boden 30 der Wärmequelle 2 und der Kühlplatte 40 Lufteinschlüsse 43 in Form von Hohlräumen vorhanden sind. Diese Lufteinflüsse 43 behindern den Wärmeübergang von der Wärmequelle 2 zur Kühlplatte 40 und damit den Übergang zum Kühlmittel 50.

FIG 2 zeigt eine Wärmequelle 2, bei der am Boden 30 eine Wärmeleitpaste 31 aufgetragen ist. Die Wärmequelle 2 mit der Wärmeleitpaste 31 wird auf die Kühlplatte 40 gepresst und dort montiert. Dieser ebenfalls aus dem Stand der Technik bekannte Aufbau verbessert den Wärmeübergang im Vergleich zur Ausführung der FIG 1.

FIG 3 zeigt Wärmequelle 2 und Kühlplatte 40 nach erfolgter Montage. Es ist zu erkennen, dass die vorher vorhandenen Lufteinschlüsse 43 bzw. Hohlräume nun vollständig mit Wärmeleitpaste 31 gefüllt sind. Die Wärmeleitpaste 31 fördert den Wärmeaustausch zwischen Wärmequelle 2 und Kühlplatte 40, so dass die Wärme an das Kühlmittel 50 übertragen werden kann.

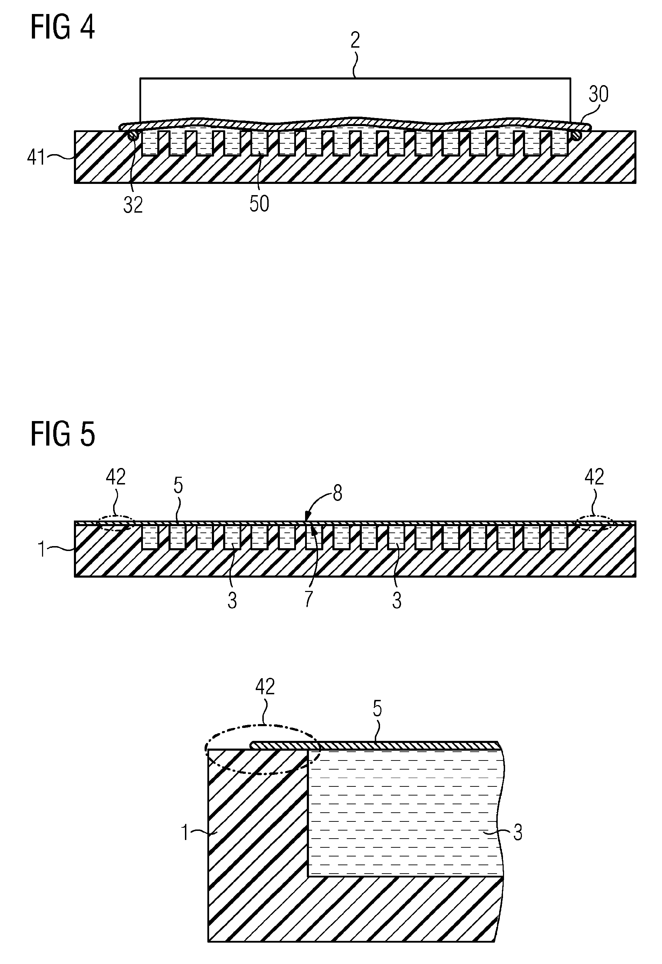

FIG 4 zeigt eine alternative Kühlplatte 41. Hierbei bildet die Wärmequelle 2 den Deckel der Kühlplatte 41, der ein Austreten des Kühlmittels 50 verhindert. Zwischen dem Boden 30 der Wärmequelle 2 und der alternative Kühlplatte 41 ist eine Dichtung 32 vorhanden, die ein Austreten des Kühlmittels 50 verhindert.

FIG 5 zeigt einen Kühlkörper 1 mit einer Folie 5. Die Folie 5 steht mit einer Oberfläche 7 mit dem flüssigen Kühlmedium 3 in Verbindung. Eine weitere Oberfläche 8 der Folie 5 ist für die Kontaktierung mit der in dieser Figur nicht dargestellten Wärmequelle 2 vorgesehen. Im Randbereich 42 des Kühlkörpers 1 ist die Folie 5 mit der Wanne des Kühlkörpers 1 verbunden. Diese Verbindung verhindert das Austreten des flüssigen Kühlmediums 3. Diese Verbindung ist derart ausgeführt, dass auch, wenn das flüssige Kühlmedium 3 unter Druck gesetzt wird, ein Austreten des flüssigen Kühlmediums sicher verhindert wird.

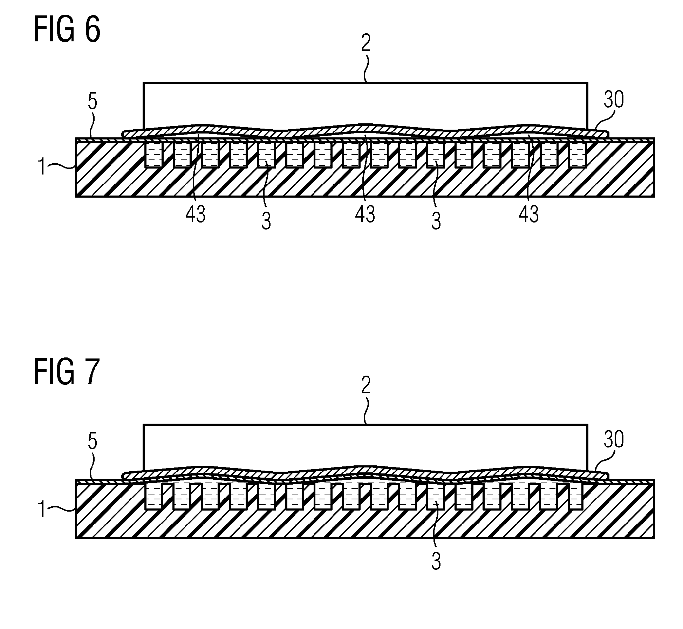

FIG 6 zeigt eine auf dem Kühlkörper 1 montierte Wärmequelle 2. Bei diesem Kühlkörper 1 steht das flüssige Kühlmedium 3 nicht unter Druck, so dass die Folie 5 an der Wanne des Kühlkörpers anliegt. Dadurch sind zwischen Boden 30 der Wärmequelle 2 und Kühlkörper 1 Lufteinschlüsse 43 bzw. Hohlräume vorhanden, die einen effizienten Wärmeaustausch zwischen Wärmequelle 2 und Kühlkörper 1 verhindern. Sobald jedoch das flüssige Kühlmedium 3 unter Druck gesetzt wird, bewegt sich die Folie 5 auf den Boden 30 der Wärmequelle 2 zu. Dieser Zustand ist in FIG 7 dargestellt. Die Folie liegt dann ohne Lufteinschlüsse an dem Boden 30 der Wärmequelle 2 an. Die Verwendung einer Wärmeleitpaste 31, wie beispielsweise in FIG 2, ist nicht erforderlich. Dadurch entsteht trotz der Unebenheiten an der Wärmequelle 2 ein flächiger Kontakt zwischen Kühlkörper 1 und Boden 30 der Wärmequelle 2, der die Hohlräume und Lufteinschlüsse 43 beseitigt. Dies verbessert den Wärmeübergang von Wärmequelle 2 zu Kühlkörper 1.

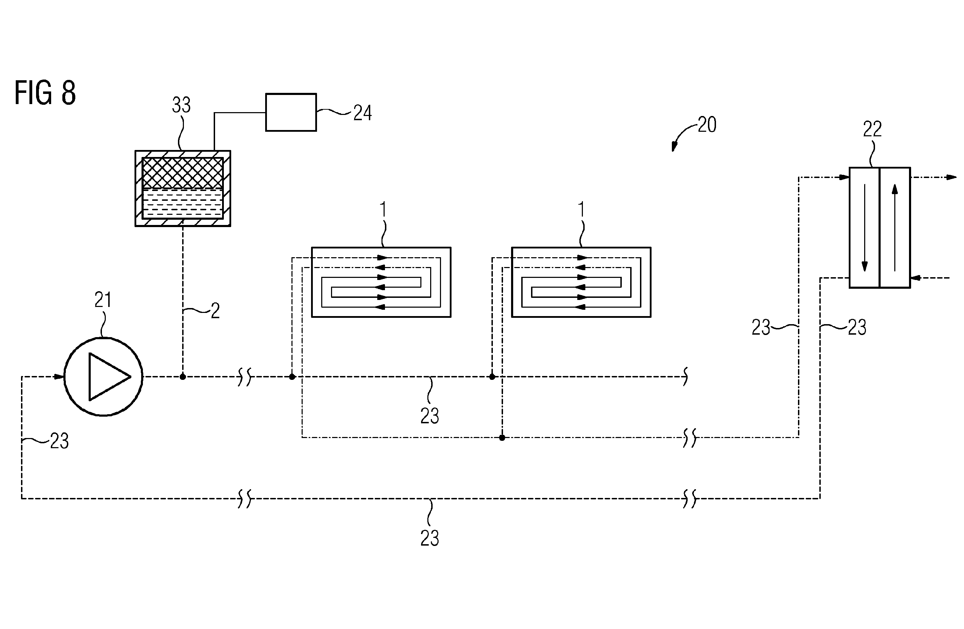

FIG 8 zeigt ein Kühlsystem 20. Dieses Kühlsystem 20 weist beispielhaft zwei Kühlkörper 1 auf, wie sie in FIG 6 oder FIG 7 dargestellt sind. Über ein Verbindungssystem 23 sind diese Kühlkörper 1 mit einem Wärmetauscher 22 und einer Pumpe 21 verbunden. Das Kühlsystem ist mit dem flüssigen Kühlmedium 3 gefüllt. Die Pumpe 21 bewirkt das Fließen des flüssigen Kühlmediums 3 im Kühlsystem 20. Dazu erzeugt die Pumpe 21 den Druck, der nötig ist, um beim erforderlichen Volumenstrom Druckabfälle in Kühlkörpern 1, Verbindungssystem 23 und Wärmetauscher 22 zu kompensieren. Der Wärmetauscher 22 führt die mit dem flüssigen Kühlmedium 3 transportierte Wärme an die Umgebung ab. Dabei kann die Wärme beispielsweise an die Umgebungsluft, an Industriewasser oder Seewasser erfolgen.

Darüber hinaus weist der Kühlkreislauf des Kühlsystems 20 ein Ausdehnungsgefäß 33 und ein Mittel 24 zur Druckerzeugung auf. Wegen der Inkompressibilität des Kühlmittels hat es sich als vorteilhaft erwiesen, das Ausdehnungsgefäß 33 vorzusehen, das Volumenänderungen des flüssigen Kühlmediums 3 auf Grund von Temperaturänderungen ermöglicht, ohne dass wesentliche Druckänderungen im Kühlsystem 20 auftreten. Dazu ist vorteilhafter Weise im Ausdehnungsgefäß 33 oberhalb des flüssigen Kühlmediums 3 ein Luft- oder Gaspolster vorhanden.

Der für das Anpressen der Folie 5 an den Boden der Wärmequelle benötigte Druck wird durch den Überdruck im Kühlkreislauf gegenüber der Umgebung erzeugt. Wegen der Inkompressibilität des flüssigen Kühlmediums 3 ist dieser gleich dem Überdruck des Gases im Ausdehnungsgefäß.

Dazu ist das Ausgleichsgefäß 33 mit dem Mittel 24 zur Druckerzeugung verbunden. Die Druckerzeugung kann dabei beispielsweise mittels eines Kompressors oder eines Druckluft- oder Gasspeichers vorgenommen werden. Darüber hinaus hat es sich als vorteilhaft erwiesen, ein Ablassventil in das Mittel 24 zur Druckerzeugung zu integrieren. Ist das Ablassventil geöffnet, das Luftpolster also mit der Umgebungsluft verbunden, dann steht auch der Kühlmittelkreis nicht unter Überdruck gegenüber der Umgebung. Die Folie 5 auf dem Kühlkörper 1 ist eben, liegt nur partiell am Modulboden an, wie beispielsweise in FIG 6 dargestellt.

Wird das Ablassventil geschlossen und beispielsweise durch einen Kompressor oder aus einem Druckgasbehälter Gas in das Ausdehnungsgefäß 33 gepresst, dann pflanzt sich dieser Druck in das flüssige Kühlmedium 3 fort und bewirkt das vollflächige Anliegen der Folie 5 an den Boden der Wärmequelle 2, wie in FIG 7 dargestellt.

Bei Betrieb der Pumpe 21 tritt entlang der Fließstrecke des Kühlmittels ein Druckabfall auf. Der Vordruck, beispielsweise erzeugt durch das Mittel 24 zur Druckerzeugung, muss so hoch sein, dass auch am Kühlmittelauslass des Kühlkörpers 1 noch ein ausreichend hoher Druck gegenüber der Umgebung herrscht, weil dieser für das Anpressen der Folie an den Boden der Wärmequelle 2 maßgeblich ist.

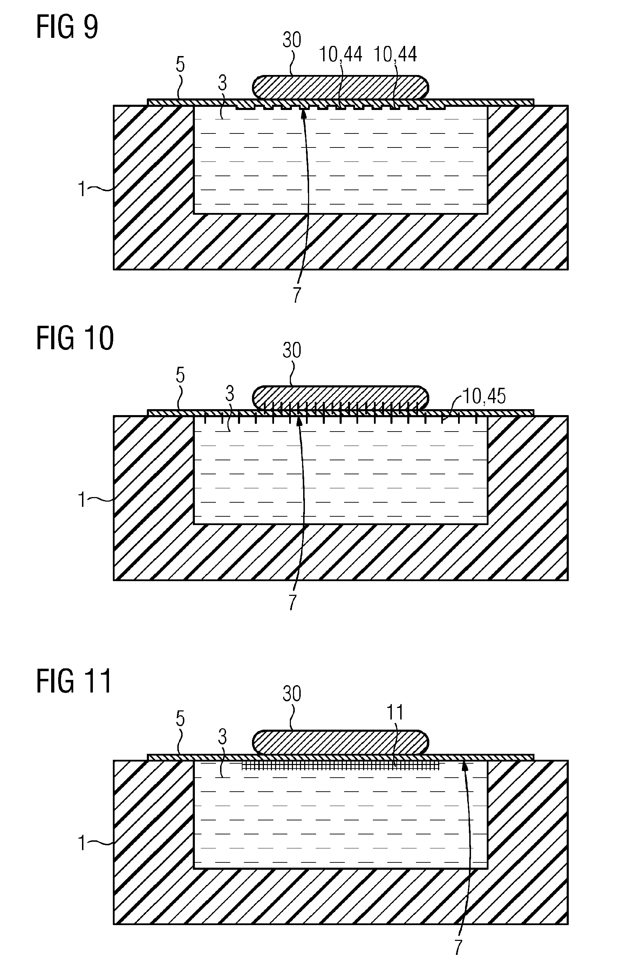

Zur Verbesserung des Wärmeübergangs von Folie 5 zum flüssigen Kühlmedium 3 kann die Folie 5 auf die in den Figuren 9 bis 12 dargestellten Weisen optimiert werden.

FIG 9 zeigt, dass die Folie 5 auf ihrer Oberfläche 7, die dem flüssigen Kühlmedium 3 zugewandt ist, hervorstehende Elemente 10 in Form von Noppen 44 aufweist. Diese Noppen 44 erhöhen die für den Wärmetransport wirksame Oberfläche zum flüssigen Kühlmedium 3, so dass die Wärme mit geringerer Temperaturdifferenz ins flüssige Kühlmedium 3 übergeht.

FIG 10 zeigt anstelle der Noppen 44 Rillen 45 als hervorstehende Elemente 10, die ebenfalls eine entsprechende Vergrößerung der wirksamen Fläche für den Wärmeübergang zum flüssigen Kühlmedium 3 und damit einen verbesserten Wärmeübergang bewirken.

FIG 11 zeigt eine auf die Folie 5 aufgebrachte, schaumartige Beschichtung 11. Diese kann beispielsweise durch einen Metallschaum realisiert werden. Auch diese vergrößert die für den Wärmeübergang wirksame Fläche von Folie 5 auf das flüssige Kühlmedium 3 und stellt damit einen guten Wärmeübergang dar.

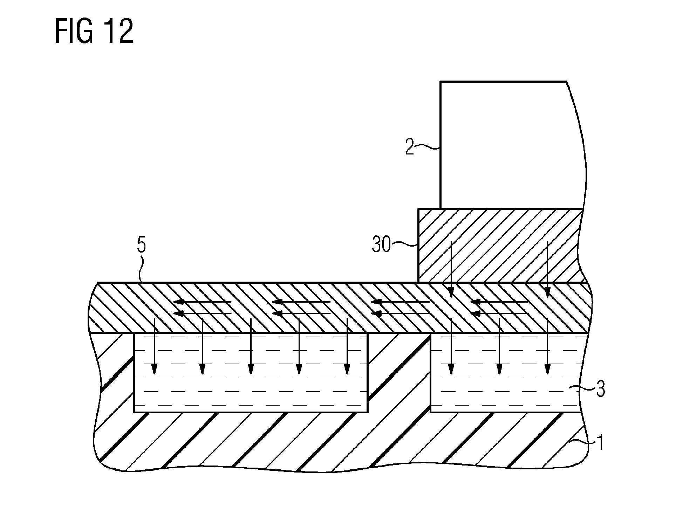

FIG 12 zeigt schematisch anhand von Pfeilen eine Folie 5 mit hoher Querleitfähigkeit in der Wärmeleitung. Die dargestellte Wärmequelle 2 leitet ihre Verlustwärme über ihren Boden 30 in die Folie 5 ein. Durch die hohe Querleitfähigkeit erfolgt die Wärmeleitung nicht ausschließlich auf kürzestem Wege durch die Folie 5 in das flüssige Kühlmedium 3, sondern die Wärme verteilt sich auch quer in der Folie 5. Dadurch spreizt sich der Wärmefluss beim Übergang von Wärmequelle 2 auf das flüssige Kühlmedium 3 auf und vergrößert somit die für den Wärmeübergang von Folie 5 auf flüssiges Kühlmedium 3 wirksame Fläche. Auch hiermit lässt sich ein guter Wärmeübergang von Wärmequelle 2 auf das flüssige Kühlmedium erzielen.

Zusammenfassend betrifft die Erfindung einen Kühlkörper zur Übertragung von Wärme einer Wärmequelle auf ein flüssiges Kühlmedium und wobei der Kühlkörper mindestens einen Kanal zur Aufnahme des flüssigen Kühlmediums aufweist. Um auf die Verwendung von Wärmeleitpaste bei der thermischen Kontaktierung von Wärmequelle und Kühlkörper verzichten zu können wird vorgeschlagen, dass der Kühlkörper eine Folie aufweist, wobei die Folie zumindest einen Teil des Kanals bildet, wobei die Folie eine Außenfläche, des Kühlkörpers bildet, die für die Kontaktierung mit der Wärmequelle vorgesehen ist, wobei die Folie derart flexibel ist, dass die Folie durch einen Druck des flüssigen Kühlmediums an die Wärmequelle gedrückt wird. Weiter betrifft die Erfindung eine Leistungshalbleitereinheit mit einem solchen Kühlkörper und einem Halbleitermodul, wobei das Halbleitermodul derart auf dem Kühlkörper angeordnet ist, dass das Halbleitermodul thermisch zumindest mit Teilen der Folie des Kühlkörpers gekoppelt ist. Ferner betrifft die Erfindung ein Kühlsystem mit einem solchen Kühlkörper oder einer solchen Leistungshalbleitereinheit sowie mit einer Pumpe, einem Mittel zur Druckerzeugung, einem Wärmetauscher und einem Verbindungssystem, wobei der Kühlkörper, die Pumpe und der Wärmetauscher mittels des Verbindungssystems derart miteinander verbunden sind, dass das flüssige Kühlmedium zwischen dem Kühlkörper, der Pumpe und dem Wärmetauscher zirkulieren kann, wobei durch das Mittel zur Druckerzeugung das flüssige Kühlmedium derart unter Druck setzbar ist, dass die Folie durch den Druck des flüssigen Kühlmediums an die Wärmequelle gedrückt wird. Des Weiteren betrifft die Erfindung ein Verfahren zur Kühlung einer Wärmequelle mittels eines solchen Kühlkörpers, wobei das flüssige Kühlmedium derart unter Druck gesetzt wird, dass die Folie des Kühlkörpers an die Wärmequelle gedrückt wird.

## Patentansprüche

1. Kühlkörper (1) zur Übertragung von Wärme einer Wärmequelle (2) auf ein flüssiges Kühlmedium (3), wobei der Kühlkörper (1) mindestens einen Kanal (4) zur Aufnahme des flüssigen Kühlmediums (3) aufweist, wobei der Kühlkörper (1) eine Folie (5) aufweist, wobei die Folie (5) zumindest einen Teil des Kanals (4) bildet, wobei die Folie (5) eine Außenfläche (6), des Kühlkörpers (1) bildet, die für die Kontaktierung mit der Wärmequelle (2) vorgesehen ist, wobei die Folie (5) derart flexibel ist, dass die Folie (5) durch einen Druck des flüssigen Kühlmediums (3) an die Wärmequelle (2) gedrückt wird.

2. Kühlkörper (1) nach Anspruch 1, wobei eine Oberfläche (7) der Folie, die zum Innern des Kanals (4) gerichtet ist, eine größere Rauigkeit aufweist als eine weitere Oberfläche (8), welche die Außenfläche (6) des Kühlkörpers (1) bildet.

3. Kühlkörper (1) nach einem der Ansprüche 1 oder 2, wobei die Oberfläche (7) der Folie (4), die zum Innern des Kanals (4) gerichtet ist, hervorstehende Elemente (10), insbesondere Noppen und/oder Rillen, oder eine schaumartige Beschichtung (11), insbesondere eine Beschichtung mit Metallschaum, aufweist.

4. Kühlkörper (1) nach einem der Ansprüche 1 bis 3, wobei die Oberfläche (7) der Folie, die zum Innern des Kanals (4) gerichtet ist, eine hohe Querleitfähigkeit für die Wärmeleitung aufweist.

5. Leistungshalbleitereinheit (15) aufweisend
- einen Kühlkörper (1) nach einem der Ansprüche 1 bis 4
- ein Halbleitermodul (16),
wobei das Halbleitermodul (16) derart auf dem Kühlkörper (1) angeordnet ist, dass das Halbleitermodul (16) thermisch zumindest mit Teilen der Folie (4) des Kühlkörpers (1) gekoppelt ist.

6. Kühlsystem (20) aufweisend
- einen Kühlkörper (1) nach einem der Ansprüche 1 bis 4 oder eine Leistungshalbleitereinheit (15) nach Anspruch 5,
- eine Pumpe (21),
- ein Mittel (24) zur Druckerzeugung,
- einen Wärmetauscher (22) und
- ein Verbindungssystem (23),
wobei der Kühlkörper (1), die Pumpe (21) und der Wärmetauscher (22) mittels des Verbindungssystems (23) derart miteinander verbunden sind, dass das flüssige Kühlmedium (3) zwischen dem Kühlkörper (1), der Pumpe (21) und dem Wärmetauscher (22) zirkulieren kann, wobei durch das Mittel (24) zur Druckerzeugung das flüssige Kühlmedium (3) derart unter Druck setzbar ist, dass die Folie (5) durch den Druck des flüssigen Kühlmediums (3) an die Wärmequelle gedrückt wird.

7. Verfahren zur Kühlung einer Wärmequelle (2) mittels eines Kühlkörpers (1) nach einem der Ansprüche 1 bis 4, wobei das flüssige Kühlmedium (3) derart unter Druck gesetzt wird, dass die Folie (4) des Kühlkörpers (1) an die Wärmequelle (2) gedrückt wird.
